(19) Europäisches Patentamt
European Patent Office
Office européen des brevets

(11) **EP 3 780 126 A1**

(12) **EUROPEAN PATENT APPLICATION**

(43) Date of publication:
**17.02.2021 Bulletin 2021/07**

(51) Int Cl.:
***H01L 41/09*** *(2006.01)*      ***H02N 2/18*** *(2006.01)*

(21) Application number: **19210311.7**

(22) Date of filing: **20.11.2019**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **12.08.2019 KR 20190098416**

(71) Applicant: **AMC. Co., Ltd.
Gyeonggi-do (KR)**

(72) Inventor: **JIN, Kyung Sihk
Gyeonggi-do (KR)**

(74) Representative: **Vossius & Partner
Patentanwälte Rechtsanwälte mbB
Siebertstrasse 3
81675 München (DE)**

(54) **NON-CONTACT CONTINUOUS PIEZOELECTRIC GENERATOR USING MAGNETIC FORCE**

(57) The present disclosure discloses a non-contact continuous piezoelectric generator using magnetic force including N+1 rotor layers each having a circular plate shape and rotated by an external energy source, N stator layers each having a circular plate shape and positioned between the rotor layers, and a support structure configured to support the rotor layers and the stator layers.

Fig. 1

## Description

CROSS-REFERENCE TO RELATED APPLICATION

This application claims priority to and the benefit of Korean Patent Application No. 10-2019-0098416, filed on Aug 12, 2019.

## BACKGROUND

### 1. Field of the Invention

The present disclosure relates to a non-contact continuous piezoelectric generator using magnetic force, and more particularly, to a non-contact continuous piezoelectric generator using magnetic force capable of minimizing initial torque generated between permanent magnets present in a stator layer, a rotor layer starting to rotate, and another rotor layer when the rotor layers start to rotate due to an external energy source in the non-contact continuous piezoelectric generator that collects various natural forces, such as wind power, tidal power, water power, and the like, or conventionally unutilized artificial energy that is not recovered but is extinguished before, for example, vibration force on a road which is generated after a vehicle passes through the road, vibration force inside the vehicle, and the like.

### 2. Description of Related Art

Piezoelectric elements are elements that use crystals, piezoelectric ceramics, or the like that generate voltage when mechanical stress is applied and, conversely, generate deformation when voltage is applied, and refers to elements that have properties of changing voltage (piezoelectric effect) when pressure is applied and, conversely, expanding or contracting when voltage is applied.

Although piezoelectric ceramics obtained by sintering quartz or barium titanate have been widely known for a long time, lead-zirconate-titanate (abbreviated as PZT), which may be found in lighters and ignition devices in gas appliances, is the most widely used. In automobiles, PZT is used for knock sensors and various pressure sensors.

Recently, various energy generating apparatuses or power generating apparatuses using such piezoelectric elements have been actively studied.

There are various techniques in the related art. For example, in Korean Patent No. 1380538 (registered on March 26, 2014), there is a description that, "A piezoelectric harvesting system using a compressive force according to the embodiment of the present disclosure includes a piezoelectric body made of a piezoelectric material and a fixture to which the piezoelectric body is attached, wherein the piezoelectric body is attached to one surface of the fixture, which is compressed, and when the compressive force is applied to the fixture, the applied compressive force is applied to the piezoelectric body to generate electrical energy. According to the embodiment of the present disclosure, the compressive force is applied while external force generated by a load and an impact is applied, and the electrical energy may be generated by using the applied compressive force." Here, there has been disclosed a technique for generating electric power using the piezoelectric body subjected to vibration force or compressive force due to an external impact.

The above-described patent relates to a technique that may be applied well when vibration force or compressive force occurs due to an impact but is difficult to apply when the vibration force or the compressive force does not occur due to the impact. Furthermore, in the conventional impact-based piezoelectric power generation, there is a risk of abrasion or damage of a piezoelectric element due to hitting or impact, and there is a problem that high-quality power is not produced because the waveform generated by piezoelectric is not generated as a sine wave.

[Prior-Art Documents]

[Patent Documents]

(Patent Document 1) Korean Patent No. 1380538 (registered on March 26, 2014), title of invention: PIEZOELECTRIC HARVESTING SYSTEM USING COMPRESSIVE FORCE.

## SUMMARY

The present disclosure is directed to providing a non-contact continuous piezoelectric generator using magnetic force in which m permanent magnets of a k-th stator layer and m permanent magnets of a (k+1)-th stator layer do not appear to overlap each other when viewed in a shaft direction of the non-contact continuous piezoelectric generator, but the m permanent magnets of the k-th stator layer and the m permanent magnets of the (k+1)-th stator layer are arranged to be staggered by an angle of θ degrees (θ is not 0 degrees), and m permanent magnets of an n-th stator layer and m permanent magnets of a first stator layer are arranged to be staggered by the angle of θ degrees (θ is not 0 degrees and where n and m are natural numbers greater than or equal to two, and k is a natural number less than or equal to n-1) to minimize initial torque generated between permanent magnets present on the stator layer, the rotor layer starting to rotate, and another rotor layer when the rotor layers start to rotate due to the external energy source.

According to an aspect of the present disclosure, there is provided a non-contact continuous piezoelectric generator using magnetic force including n+1 rotor layers each having a circular plate shape and rotated by an external energy source, n stator layers each having a circular plate shape and positioned between the rotor layers, and a support structure configured to support the rotor layers and the stator layers, wherein m permanent magnets (r) are uniformly disposed on each of the rotor layers at a constant angle of $\dfrac{360}{m}$ degrees along a circumference of the rotor layer, and when viewed in a shaft direction of the non-contact continuous piezoelectric generator, magnetic poles of the permanent magnets (r) between the rotor layers, which are adjacent to each other, are arranged to be staggered by 180°, in each of the stator layers, m unit devices, each of which is a combination of a permanent magnet (r), in which attraction and repulsion act between a permanent magnet (s) of each the rotor layers, and a piezoelectric element coupled to the permanent magnet (s) through an intermediate medium and configured to continuously drive to generate energy, are uniformly arranged along a circumference of the stator layer at a constant angle of $\dfrac{360}{m}$ degrees, and when the rotor layers start to rotate due to the external energy source, in order to minimize initial torque generated between permanent magnets present on the stator layers and the rotor layers, m permanent magnets of a k-th stator layer and m permanent magnets of a (k+1)-th stator layer do not appear to overlap each other when viewed in the shaft direction of the non-contact continuous piezoelectric generator, and the m permanent magnets of the k-th stator layer and the m permanent magnets of the (k+1)-th stator layer are arranged to be staggered by an angle of θ degrees (θ is not 0 degrees), and m permanent magnets of an n-th stator layer and m permanent magnets of a first stator layer are arranged to be staggered by the angle of θ degrees (θ is not 0 degrees and where n and m are natural numbers greater than or equal to two, and k is a natural number less than or equal to n-1).

When the sum of m angle differences between the m permanent magnets of the k-th stator layer and the m permanent magnets of the (k+1)-th stator layer is $\theta_k$, when θn is the sum of the differences between the angles of the m permanent magnets of the n-th stator layer and the m permanent magnets of the first stator layer, and when one of a clockwise direction and a counterclockwise direction is selected, a positive direction of $\theta_k$ may

be $\displaystyle\sum_{k=1}^{n} \theta k = l \times 360$ degrees when viewed in the shaft direction of the non-contact continuous piezoelectric generator (where 1 is an integer).

When the sum of m angle differences between the m permanent magnets of the k-th stator layer and the m permanent magnets of the (k+1)-th stator layer is $\theta_k$, when θn is the sum of the differences between the angles of the m permanent magnets of the n-th stator layer and the m permanent magnets of the first stator layer, and when one of a clockwise direction and a counterclockwise direction is selected, a positive direction of $\theta_k$ may be $\theta_1=\theta_2=...=\theta_k=...=\theta_n=\pm 360$ degrees/n, and

$\displaystyle\sum_{k=1}^{n} \theta k = \pm 360$ degrees when viewed in the shaft direction of the non-contact continuous piezoelectric generator.

The unit device may have a structure capable of being continuously driven on the stator layer having a circular plate shape.

The unit device may be restricted in movement in a vertical direction with respect to the stator layer and only allowed to be displaced in a planar direction of the stator layer due to a stopper structure in which one end of the unit device at an inner side is fixed to an inner side of the stator layer, and the other end of the unit device at an outer side is formed on upper and lower portions of an outer circumference of the stator layer in the vertical direction with respect to the stator layer.

The unit device may include the permanent magnet (s), the piezoelectric element, and stainless steel (SUS), which is an intermediate medium present between the permanent magnet (s) and the piezoelectric element, the permanent magnet (s) may be bonded to the intermediate medium using an adhesive, and the piezoelectric element may be also bonded to the intermediate medium using an adhesive.

The unit device may include a two-layer piezoelectric element, and the unit device including the two-layer piezoelectric element may be composed of an upper piezoelectric element, stainless steel that is an upper-intermediate medium, a permanent magnet (s), stainless steel that is a lower-intermediate medium, and a lower piezoelectric element, each of which is bonded with an adhesive and disposed in this order.

The unit device may include a three-layer piezoelectric element, and the unit device including the three-layer piezoelectric element may be composed of a first piezoelectric element, stainless steel that is a first intermediate medium, a first permanent magnet (s), stainless steel that is a second intermediate medium, a second piezoelectric element, stainless steel that is a third intermediate medium, a second permanent magnet (s), stainless steel that is a fourth intermediate medium, and a third piezoelectric element, each of which is bonded with an adhesive and disposed in this order.

In the unit device, a plurality of perforations may be formed in the SUS, which is the intermediate medium, so as to enhance adhesion between the piezoelectric element and the intermediate medium and to allow the piezoelectric element to have a greater displacement.

In the unit device, the piezoelectric element may be reinforced by being coated with a nickel thin film.

In the unit device, a mesh network reinforcement foam may be attached to the piezoelectric element so as to cover the piezoelectric element.

In the unit device, a mesh of SUS may cover the piezoelectric element to reinforce the piezoelectric element.

In the unit device, the permanent magnet (s) may be formed at an intermediate position of the SUS, which is the intermediate medium, in a circumferential direction. When the permanent magnet of the unit device is subjected to the attraction and repulsion by the permanent magnets of the rotor layer and the stator layer, an intermediate position of the unit device may move in a vertical direction with respect to the stator layer, and an outer end of the unit device may be restricted in movement in the vertical direction with respect to the planar direction of the stator layer of the unit element due to a stopper structure in which the outer end is formed on upper and lower portions of an outer circumference of the stator layer in the vertical direction with respect to the stator layer, and as a result, the unit device is displaced only in the planar direction of the stator layer so that the unit device is driven continuously to generate energy.

**BRIEF DESCRIPTION OF THE DRAWINGS**

The above and other objects, features, and advantages of the present disclosure will become more apparent to those of ordinary skill in the art by describing exemplary embodiments thereof in detail with reference to the accompanying drawings, in which:

FIG. 1 is an example of a unit harvester applicable to a non-contact continuous piezoelectric generator using magnetic force according to an exemplary embodiment of the present disclosure;
FIG. 2 illustrates an embodiment of a non-contact continuous piezoelectric generator using magnetic force to which the unit harvester of FIG. 1 is applied;
FIG. 3 illustrates another embodiment of a non-contact continuous piezoelectric generator using magnetic force to which the unit harvester of FIG. 1 is applied in plural;
FIG. 4 is a side view of another embodiment of the non-contact continuous piezoelectric generator using magnetic force to which the unit harvester of FIG. 1 is applied in plural;
FIG. 5 is a side view of still another embodiment of a non-contact continuous piezoelectric generator using magnetic force to which the unit harvester of FIG. 1 is applied in plural;
FIG. 6 is a side view of yet another embodiment of a non-contact continuous piezoelectric generator using magnetic force to which the unit harvester of FIG. 1 is applied in plural;
FIG. 7A is a cross-section showing that a rotor (R1), a stator (S1), a rotor (R2), and a stator (S2) are arranged in this order when the piezoelectric generator is cut in a lateral direction, and FIG. 7B is a cross-section viewed from the side when the piezoelectric generator is cut in a longitudinal direction;
FIG. 8 illustrates an embodiment of a non-contact continuous piezoelectric generator using magnetic force in which magnets are installed on a plurality of plates that are linearly reciprocated by rotational force, which is converted into linear reciprocating movement, due to natural force and the like, and a plurality of unit harvesters are applied to the plurality of plates that are fixed;
FIG. 9 is a view for describing an example of a design in which magnetic force of a first magnetic material and magnetic force of a second magnetic material are balanced with each other to be offset, or the total magnetic force is evenly distributed over the entire driving section throughout a module applied to a driving shaft by controlling or combining the strength of magnetic force of the first magnetic material and the second magnetic material or attraction and repulsion of an N-pole and an S-pole;
FIG. 10 is a view illustrating a method of configuring or manufacturing a piezoelectric element in a single layer or a plurality of layers so that one or both ends of the element slide when the piezoelectric element deforms due to external energy by making the one end or the both ends of the piezoelectric element open in addition to the case in which the both ends of the piezoelectric element are fixed;
FIG. 11 illustrates a case in which the non-contact continuous piezoelectric generator using magnetic force illustrated in FIG. 4 has n+1 rotor layers and n stator layers;
FIG. 12 illustrates an (n+1)-th rotor layer having a circular plate shape, on which m permanent magnets are arranged at equal intervals, in the non-contact continuous piezoelectric generator using magnetic force of FIG. 11;
FIG. 13 illustrates an n-th stator layer having a circular plate shape, on which m unit devices are arranged at equal intervals, in the non-contact continuous piezoelectric generator using magnetic force of FIG. 11;
FIG. 14 is a view illustrating unit devices of a first stator layer, a second stator layer, a third stator layer, and a fourth stator layer arranged to be staggered in the non-contact continuous piezoelectric generator using magnetic force of FIG. 11 and is a conceptual diagram for dividing the magnetic force to minimize initial starting torque;
FIG. 15 is a view illustrating a case in which one end of the piezoelectric element is open and that explains that the piezoelectric element is displaced in a horizontal direction while a permanent magnet positioned at the center of the piezoelectric element is bent; and
FIG. 16 is a view illustrating a case in which both ends of the piezoelectric element are open and that explains that the piezoelectric element is displaced in a horizontal direction while a permanent magnet positioned at the center of the piezoelectric element is bent.

## DETAILED DESCRIPTION OF EXEMPLARY EMBODIMENTS

Hereinafter, exemplary embodiments of the present disclosure will be described in detail with reference to the attached drawings. Before this, it should be understood that the terms used in the present specification and the appended claims should not be construed as limited to general and dictionary meanings but interpreted based on the meanings and concepts corresponding to technical aspects of the present disclosure on the basis of the principle that the inventor is allowed to define terms appropriately for the best explanation.

Accordingly, the embodiments described in the present specification and the components illustrated in the drawings are one preferred embodiment of the present disclosure that does not cover all of the technical ideas of the present disclosure. Thus, it should be understood that various changes and modifications may be made at the time of filing the present application.

A non-contact continuous piezoelectric generator using magnetic force according to an embodiment of the present disclosure includes a first magnetic material and a second magnetic material that are not in contact with the first magnetic material and configured to exchange magnetic force with the first magnetic material according to the driving of the first magnetic material, wherein the first magnetic material and the second magnetic material are attached directly or indirectly to a first piezoelectric element and a second piezoelectric element, respectively, and electricity is generated in the first piezoelectric element by the first magnetic material, which is continuously driven by non-contact magnetic force with the second magnetic material, or electricity is generated in the second piezoelectric element by the second magnetic material, which is continuously driven by non-contact magnetic force with the first magnetic material. Here, the term "attached indirectly" refers to a case in which the magnetic material is attached to the piezoelectric element through a medium interposed therebetween. The term "continuously driven" refers to a case in which a sine wave is generated in the piezoelectric element by the non-contact magnetic force in a manner in which a plurality of sine waves are continuously generated.

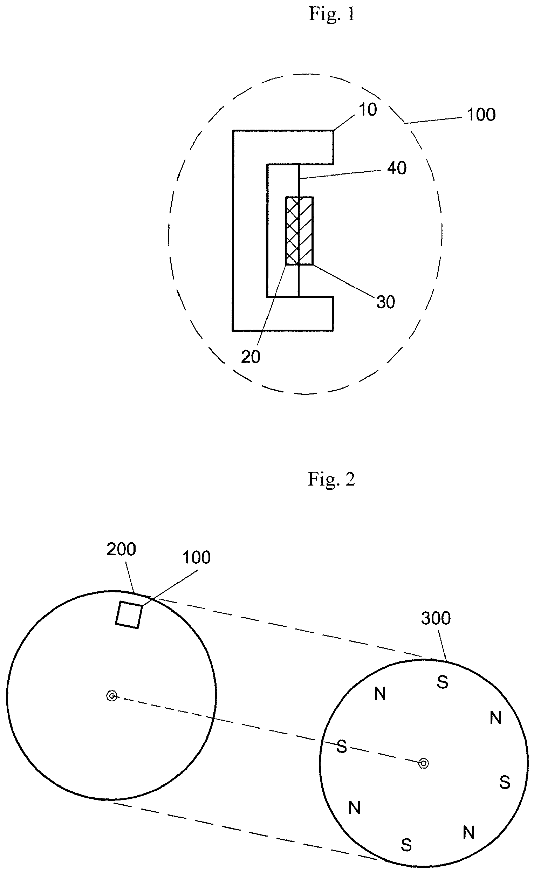

FIG. 1 is an example of a unit harvester applicable to a non-contact continuous piezoelectric generator using magnetic force according to an exemplary embodiment of the present disclosure, and FIG. 2 illustrates an example of a non-contact continuous piezoelectric generator using magnetic force to which the unit harvester of FIG. 1 is applied.

As illustrated in FIG. 1, a unit harvester 100 is a piezoelectric element mounted on a jig or an object 10 so as to vibrate and may include a first magnetic material 30 partially or fully exposed externally so as to react to external magnetic force and a first piezoelectric element 20 disposed on a back surface of the first magnetic material 30.

FIG. 1 is an example for the description, and as described above, even in the case of the second magnetic material, piezoelectric power generation may occur in the second piezoelectric element, to which the second magnetic material is directly or indirectly attached, by allowing the second magnetic material to be continuously driven by non-contact magnetic force with the first magnetic material.

The first magnetic material 30 and the first piezoelectric element 20 may be integrally manufactured by being stacked, and the first magnetic material 30 may be elastically coupled to the first piezoelectric element 20 such that vibration between the first piezoelectric element 20 and the first magnetic material 30 is generated in addition to vibration between the first magnetic material 30 and the first piezoelectric element 20, and the jig or the object 10.

As illustrated in FIG. 2, an object 200 includes a first magnetic material 30 and a first piezoelectric element attached directly or indirectly to the first magnetic material 30, and a second magnetic material configured to provide magnetic force to the first magnetic material of the above-described object 200 is disposed or installed on a rotor 300. As described above, even in the case of the second magnetic material, piezoelectric power generation may occur in the second piezoelectric element, to which the second magnetic material is directly or indirectly attached, by allowing the second magnetic material to be continuously driven by the non-contact magnetic force with the first magnetic material.

As illustrated in FIG. 2, the non-contact continuous piezoelectric generator according to the present embodiment includes the object 200 (e.g., stator) on which the unit harvester 100 illustrated in FIG. 1 is disposed or installed and the rotor 300 on which the second magnetic material configured to supply the magnetic force to the first magnetic material 30 of the unit harvester 100 is disposed or installed.

In order to generate repulsion and attraction, the first piezoelectric element receives the magnetic force from the second magnetic material mounted on the rotor 300 and thus vibrates or moves relative to the jig or the object 10 using an elastic member such as a spring 40. However, the component having the reference number "40" is not limited to an elastic member such as a spring and may be a plate-shaped member capable of bending or moving (sliding).

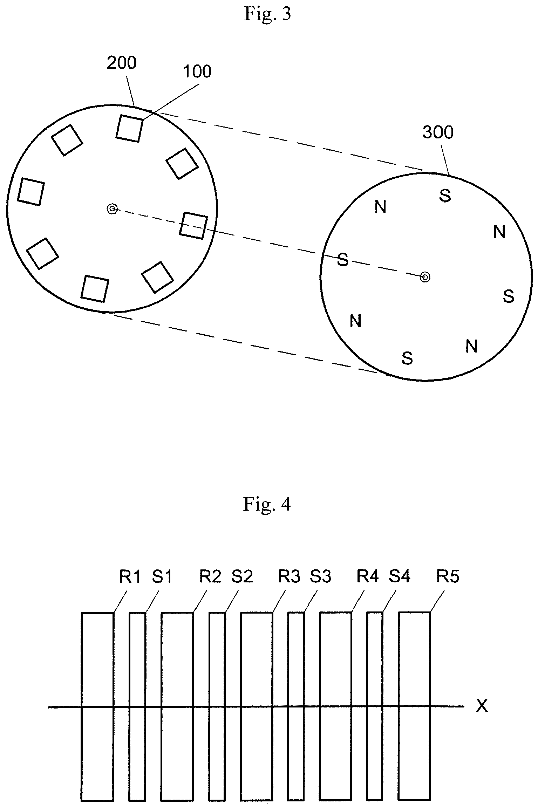

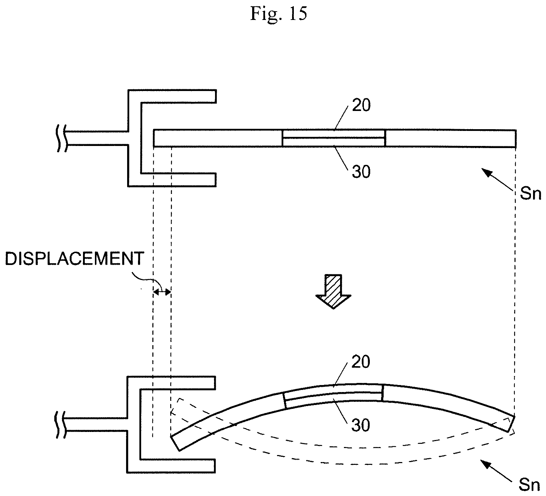

For example, as described in claim 5, the unit harvester, which is disposed on the stator layer and composed of the magnetic material (permanent magnet) and the piezoelectric element, is implemented such the unit harvester is restricted in bending movement in a vertical direction with respect to the stator layer and appears to be decreased and increased in length in a planar direction of the stator layer due to a stopper structure in which one end of the unit harvester at an inner side is fixed to an inner side of the stator layer (i.e., toward the center of the stator layer having a circular shape), and the other end (i.e., toward an outer circumference of the stator layer having a circular shape) of the unit device at an outer side is formed on upper and lower portions of the outer circumference of the stator layer in the vertical direction (i.e., in the shaft direction of the stator layer, for example, a rotation shaft direction (an X-axis direction) in FIG. 4)) with respect to a plane of the stator layer, and as a result, the unit harvester is only allowed to be displaced in the planar direction of the stator layer, (see FIG. 15).

As illustrated in FIG. 3, the object 200 may include a plurality of first magnetic materials 30 and a plurality of first piezoelectric elements 20 each attached directly or indirectly to the first magnetic material 30, and a plurality of second magnetic materials each providing magnetic force to the first magnetic material of the object 200 may be disposed or installed on the rotor 300.

One or more second magnetic materials may be disposed or installed on the rotor 300, but the second magnetic material may be disposed on the rotor in such a quantity that the magnetic force, such as repulsion and attraction to the first magnetic material 30 of the unit harvester, is provided as much as possible.

Here, the second magnetic materials of the rotor 300 may be arranged or installed at corresponding positions that provide the maximum magnetic force to the first magnetic materials. Furthermore, the number of the second magnetic materials may be selected so as to correspond to the frequency of vibration with respect to the jig or the object 10.

Specifically, it is not always desirable to have a large number of second magnetic materials, because when the frequency at which the piezoelectric element vibrates with respect to the jig or the object 10 using the elastic member such as the spring 40 is high, the large number of second magnetic materials may only disturb the vibration. Accordingly, the second magnetic materials may be disposed in a quantity corresponding to the frequency of vibration with respect to the jig or the object 10.

In addition, the piezoelectric energy generated by the first piezoelectric element may be stored in an electric energy storage mounted on the object 10 or the object 200 by utilizing a part or an entirety of the elastic member, such as a spring 40, as a circuit line,

FIG. 4 is a side view of another embodiment of a non-contact continuous piezoelectric generator using magnetic force to which a plurality of unit harvesters of FIG. 1 are applied. Rotors R1, R2, R3, R4, and R5 are fixed to an X-axis that is a rotation shaft, and the rotors R1, R2, R3, R4, and R5 rotate with relation to the rotation of the X-axis in synchronization therewith. On the contrary, although not illustrated in the drawing, at least one unit harvester 100 illustrated in FIGS. 1 to 3 is disposed or installed on each of stators S1, S2, S3, and S4 that do not rotate due to being connected and fixed to an inside of a cylinder structure such as a cylinder.

Second magnetic materials configured to provide magnetic force to the first magnetic material 30 of the unit harvester installed on each of the stators S1, S2, S3, and S4, which are the above-described objects, are disposed or installed on each of the rotors R1, R2, R3, R4, and R5 that rotate due to various natural forces, such as wind power, tidal power, water power, and the like, or unutilized artificial energy that is not recovered but is extinguished.

Similar to FIG. 3, one or more second magnetic materials may be disposed or installed on each of the rotors R1, R2, R3, R4, and R5, but the second magnetic material may be disposed on the rotor in a quantity that provides the magnetic force, such as repulsion and attraction, to the first magnetic material 30 of the unit harvester as much as possible.

As described above with reference to FIG. 3, in this case, the number of the second magnetic materials may be selected in consideration of the vibration frequency when the piezoelectric element vibrates or moves relative to the jig or the object (e.g., stator) or reciprocates such as by bending or sliding using the elastic member such as the spring 40.

Furthermore, it is also possible to design the present disclosure such that the X-axis has enough of a fixed force with respect to the rotors R1, R2, R3, R4, and R5 to provide a structure in which the rotors R1, R2, R3, R4, and R5 rotate due to natural force and the like but has some elasticity with respect to the rotors R1, R2, R3, R4, and R5 so as to allow relative movement between the rotors R1, R2, R3, R4, and R5. Meanwhile, the number of the rotors and the stators (objects) may vary depending on the design environment or conditions.

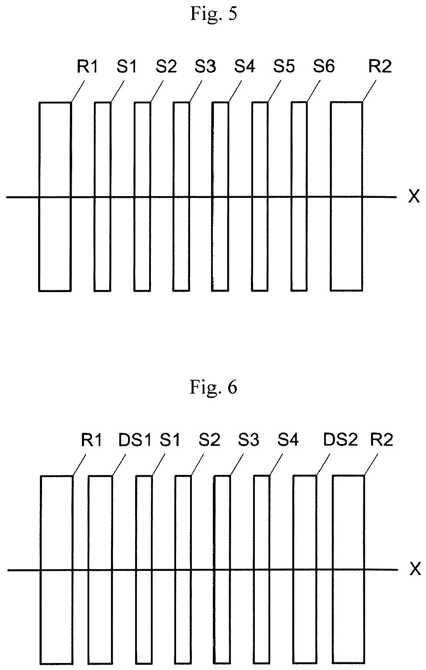

FIG. 5 is a side view of still another embodiment of a non-contact continuous piezoelectric generator using magnetic force to which a plurality of unit harvesters of FIG. 1 are applied. The difference from the embodiment illustrated in FIG. 4 is that the present embodiment has a configuration in which rotors R1 and R2 are formed only at both ends of the piezoelectric generator instead of arranging a rotor and a stator (object) alternately, and stators S1, S2, S3, S4, S5, S6, and S7 (that is, objects) are arranged in the remaining portion of the piezoelectric generator. Similar to FIG. 4, although not illustrated in the drawing, at least one unit harvester 100 illustrated in FIGS. 1 to 3 is disposed or installed on each of the stators S1, S2, S3, S4, S5, and S6 that do not rotate by being connected and fixed to an inside of a cylinder structure such as a cylinder. A magnetic material having a stronger magnetic force than that of the magnetic material installed on the rotor illustrated in FIG. 4 may be disposed on the rotor of FIG. 5.

FIG. 6 is a side view of yet another embodiment of a non-contact continuous piezoelectric generator using magnetic force to which a plurality of unit harvesters of FIG. 1 are applied. The difference from the embodiment illustrated in FIG. 5 is that the unit harvester 100 is not disposed on stators (objects) adjacent to rotors R1 and R2. This is because dummy stators DS1 and DS2 are further disposed or installed in consideration of the possibility of colliding with each other in an unexpected situation in relation to the rotors R1 and R2.

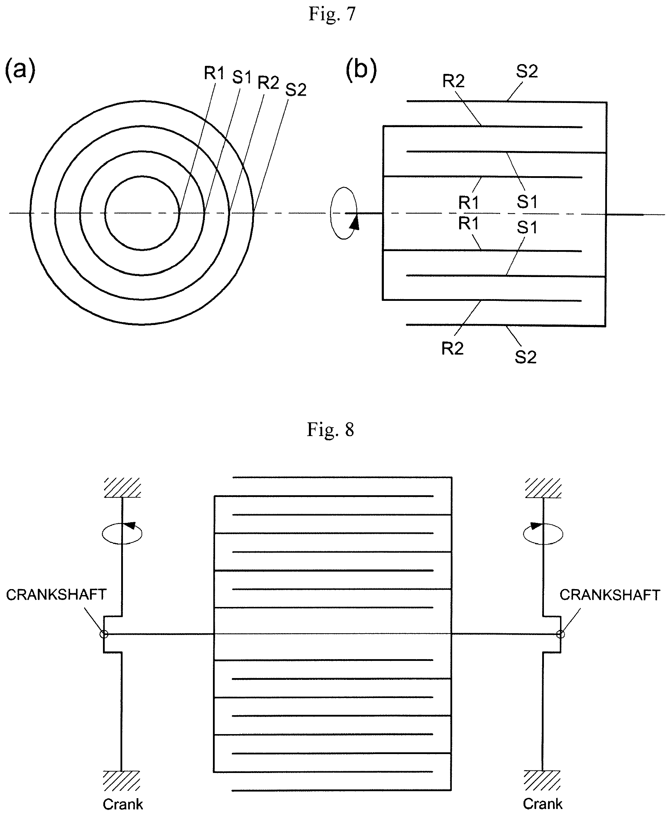

FIG. 7A is a cross-section showing that the rotor R1, the stator S1, the rotor R2, and the stator S2 are arranged in this order when the piezoelectric generator is cut in a lateral direction, and FIG. 7B is a cross-section viewed from the side when the piezoelectric generator is cut in a longitudinal direction. As shown in FIG. 7B, the rotors R1 and R2 have the same shaft in an upper portion so that the rotor R1 and the rotor R2 may rotate at the same time when the shaft rotates, and the stators S1 and S2 (that is, objects) are fixed to a lower shaft. Magnetic materials are arranged on the rotor on the surface of a cylinder and the unit harvester 100 is disposed on each of the stators S1 and S2 (e.g., object). It is to be understood that the present disclosure is not limited to this configuration, and the linear reciprocating movement in the shaft direction of the rotor may be one form of driving the present disclosure.

FIG. 8 illustrates an embodiment of a non-contact continuous piezoelectric generator using magnetic force in which magnets are installed on a plurality of plates that are linearly reciprocated by rotational force, which is converted into linear reciprocating movement, due to natural force and the like, and a plurality of unit harvesters are applied to the plurality of plates that are fixed. Converting the rotational force by natural force and the like into the linear reciprocating movement is possible using a crank. Although not illustrated in FIG. 8, a plurality of plates fixed to the right side of FIG. 8 may be linearly reciprocated in a manner similar to the linear reciprocating movement of the plurality of plates on the left side of FIG. 8. However, the plurality of plates may be reciprocated linearly so as to move relatively.

Here, the first magnetic material or the second magnetic material is sufficient when the magnetic material is a material capable of self-magnifying itself such as permanent magnets or soft magnetic materials, or materials or a collection of materials that have magnetic force by being magnetized strongly when external magnetic field is slightly applied. Further, the first magnetic material or the second magnetic material may be made of an electromagnet. However, here, the case in which the magnetic material is a permanent magnet will be described as a representative example of the present disclosure.

Materials for the power generation used in the present disclosure include piezoelectric materials in addition to the permanent magnets and the soft magnetic materials described above. The first piezoelectric element or the second piezoelectric element is an element made of a conventional piezoelectric material.

In addition, the first magnetic material and/or the second magnetic material may have a plurality of flat plate-shaped structures or may have a plurality of cylindrical-shaped structures. Here, the flat plate-shaped structure may be in the form of a circular plate or a polygonal-shaped plate. The cylindrical-shaped structure may be formed of a cylinder structure. Here, the polygonal-shaped plate will be described as a representative example.

When a power generation plate, which is a plate made for piezoelectric power generation, has a flat plate shape, the power generation plate may be manufactured in the following three forms.

(1) The piezoelectric elements may be manufactured by dividing one material for power generation into an entirety or a portion of the polygonal-shaped plate without physically separating the one material for power generation but dividing the piezoelectric elements into two or more piezoelectric elements, and by attaching or bringing one or more magnetic materials close to each piezoelectric element so that each piezoelectric element is capable of generating piezoelectric power, (2) the piezoelectric elements may be manufactured by attaching two or more magnetic materials and two or more piezoelectric elements to a substrate, directly or indirectly, and attaching or bringing one or more magnetic materials close to each piezoelectric material so that each piezoelectric element is capable of generating piezoelectric power, and (3) the piezoelectric elements may be manufactured by processing the substrate according to the shape of the material for power generation or installing a structure in the form of the substrate so as to correspond to the shape of the material for power generation so that each kind of material for power generation may be installed on the structure, and attaching or bringing the material for power generation close in a single layer or in multiple layers but attaching or bringing two or more piezoelectric elements close in a different partition on the same substrate and attaching or bringing one or more magnetic materials close to each piezoelectric material so that each piezoelectric element is capable of generating piezoelectric power.

When a power generation plate, which is a plate made for piezoelectric power generation, has a cylindrical shape, the power generation plate may be manufactured in the following three forms.

(1) The piezoelectric elements may be manufactured by dividing one material for power generation into an entirety or a portion of the cylindrical plate surface without physically separating the one material for power generation but dividing the piezoelectric elements into two or more piezoelectric elements, and by attaching or bringing one or more magnetic materials close to each piezoelectric element so that each piezoelectric element is capable of generating piezoelectric power, (2) the piezoelectric elements may be manufactured by attaching two or more magnetic materials and two or more piezoelectric elements to the plate, directly or indirectly, and attaching or bringing one or more magnetic materials close to each piezoelectric element so that each piezoelectric element is capable of generating piezoelectric power, and (3) the piezoelectric elements may be manufactured by processing a cylindrical plate surface according to the shape of the material for power generation or installing a structure in the form of the cylindrical plate surface so as to correspond to the shape of the material for power generation so that each kind of material for power generation may be installed on the structure, and attaching or bringing the material for power generation in a single layer or in multiple layers close, but attaching or bringing two or more piezoelectric elements close in a different partition on the same substrate and attaching or bringing one or more magnetic materials close to each piezoelectric element so that each piezoelectric element is capable of generating piezoelectric power.

Further, the term "attaching" as used herein refers to mechanically integrating the material for power generation with the substrate by attaching the material for power generation to the substrate in a physical or chemical manner or through another material, and the term "bringing close" as used herein refers to the installation of the material for power generation close enough to the substrate to give a direct or indirect physical impact. In addition, the term "directly" refers to the case of direct contact, and the term "indirectly" refers to the case of contacting or influencing via a medium or a parameter layer even though contact is not made directly.

Here, each of the first magnetic material and the second magnetic material has a flat plate-shaped structure or a cylindrical-shaped structure, and the driving of the first magnetic material or the second magnetic material includes at least one of a forward and backward reciprocating movement, a horizontal reciprocating movement, vertical reciprocating movement, a linear reciprocating movement, and a rotational movement with respect to each other.

Here, the forward and backward reciprocating movement, the horizontal reciprocating movement, the vertical reciprocating movement, the linear reciprocating movement, and the rotational movement are relative movements and refer to a movement that may cause a continuous piezoelectric power generation and refer to the relative movement that allows continuous movement rather than the one-time or irregular environment in a conventional impact-based piezoelectric power generation. Thus, a sine wave or a waveform that is close to the sine wave may be generated unlike the impulse waveform of the conventional impact-based piezoelectric power generation. That is, the waveform of the electricity generated from the first piezoelectric element or the second piezoelectric element is a waveform in which both the "+" wave and the "-" wave are generated. FIGS. 2 and 3 are exemplified based on the rotational movement. However, the present disclosure is not limited to FIGS. 2 and 3, and various linear reciprocating movements (in FIG. 8, only one side is illustrated as moving, but both sides may move) such as a forward and backward reciprocating movement, a horizontal reciprocating movement, and a vertical reciprocating movement may be included, and two cylindrical plates with a cylinder structure may perform a rotational movement. Of course, it is also possible that movement of the two cylindrical plates with a cylinder structure may be relatively linearly reciprocated.

In other words, in the case of the cylindrical plate, the plate may move to be parallel to a longitudinal direction of the plate, or the plate may move individually or in combination with linear motion and curved motion such as by rotating around the center of the cross-section of the plate. The diameter of the plate of the cylindrical plate refers to the diameter of the cross-section of the plate or the length in a diagonal direction.

Further, the first piezoelectric element or the second piezoelectric element is manufactured in a structure in which each of the first piezoelectric element and the second piezoelectric element is continuously displaced or deformed two or more times so that piezoelectric power is continuously generated two or more times. In addition, the piezoelectric generator may be used as a hybrid power generator by mixing the piezoelectric generator with the existing winding type power generator.

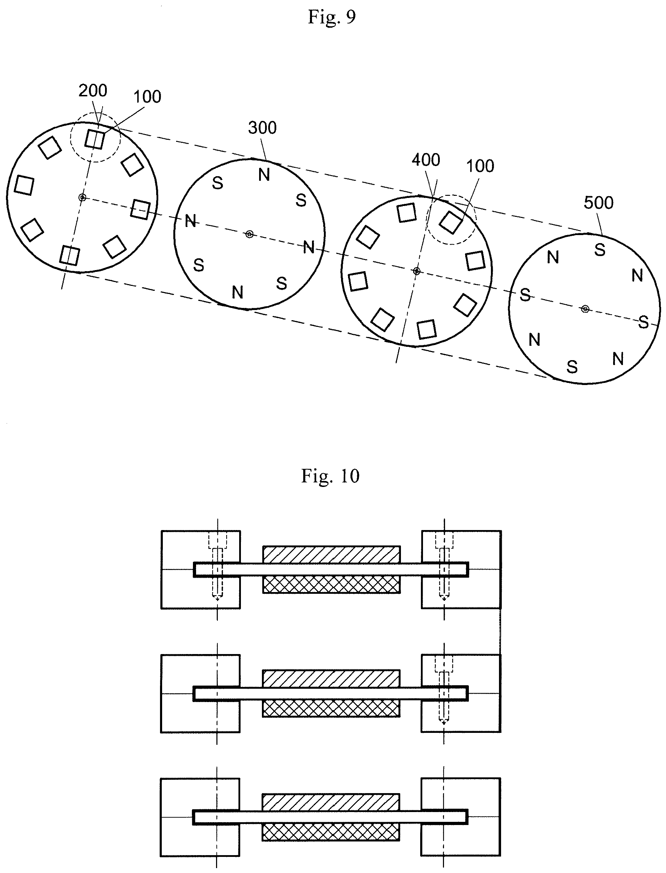

Meanwhile, FIG. 9 is a view for describing an example of a design in which the magnetic force of the first magnetic material and the magnetic force of the second magnetic material are balanced with each other to be offset, or the total magnetic force is evenly distributed over the entire driving section throughout a module applied to a driving shaft by controlling or combining the strength of the magnetic force of the first magnetic material and the second magnetic material or attraction and repulsion of an N-pole and an S-pole.

That is, as illustrated in FIG. 9, two stators with eight unit harvesters in one stator are prepared, eight unit harvesters are disposed in each stator, and then the two stators are disposed to be staggered with each other so as to maximize the magnetic force of the magnetic materials. That is, the stators are disposed to be staggered with each other so as to maximize the magnetic by placing the position (see circular dotted line) of the magnetic material of the leftmost stator in the space between the magnetic materials of the stator disposed third from the left (see circular dotted line). Thus, when assuming the waveform of the magnetic force, it is possible to divide a large upper peak (peak) and a large lower peak (valley) of the magnetic force into two half-sized upper peaks (peaks) and two half-sized lower peaks (valleys).

As described above, the first magnetic material or the second magnetic material may be started with less energy at an initial startup and the power generation efficiency may be improved by being designed so that the magnetic force of the first magnetic material and the magnetic force of the second magnetic material are balanced with each other to be offset, or the total magnetic force is evenly distributed over the entire driving section throughout the module applied to the driving shaft by controlling or combining the strength of the magnetic force of the first magnetic material and the second magnetic material or attraction and repulsion of the N-pole and the S-pole.

Actually, when the magnetic force is composed of large peaks and large valleys, the magnetic force was so strong that the magnetic materials do not start (rotate) properly initially, but when the magnetic force is divided into two half-sized peaks and two half-sized valleys, initial start-up (rotation) is more easily performed, that is, driven with minimum energy, thereby improving power generation efficiency.

Further, the first magnetic material or the second magnetic material that is not in contact with the first piezoelectric element or the second piezoelectric element but uses attraction and repulsion to generate energy in a state in which the module is completely shielded from external humidity or moisture to prevent an electric circuit function inside the module from being impaired or lost and to prevent the material inside the module from being corroded in manufacturing the first magnetic material and the second magnetic material in a separate module or in a single module.

A piezoelectric energy harvesting method developed heretofore generates many high frequencies due to the impact of energy applied from the outside, which causes many adverse effects not only to the charging of generated electricity but also to a circuit and causes an increase in internal impedance. In addition, in the case of conventional impact-based piezoelectric power generation, a device for impacting a piezoelectric element occupies most of a module which becomes a major obstacle in improving the integration of the piezoelectric element and impacting the piezoelectric element has become a critical factor in shortening the lifespan of the element.

Here, it is also possible to manufacture the piezoelectric material in a single layer or a multilayer by pressing a spacer against the center of one or more piezoelectric elements attaching the spacer to the center of one or more piezoelectric elements. As described above, it is also possible to protect the material by applying a polymer to the surface of one or more piezoelectric elements and to manufacture the piezoelectric element in a block form by being molded into a single layer or a double layer using a polymer.

Further, the first piezoelectric element or the second piezoelectric element is molded with epoxy or polymer, or the epoxy or polymer is applied to the surface of the first piezoelectric element or the second piezoelectric element so that the first piezoelectric element or the second piezoelectric element may be used semi-permanently. In addition, a plurality of first piezoelectric elements or a plurality of second piezoelectric elements are integrated and molded with epoxy or polymer to increase the amount of piezoelectric power generation per unit area or volume.

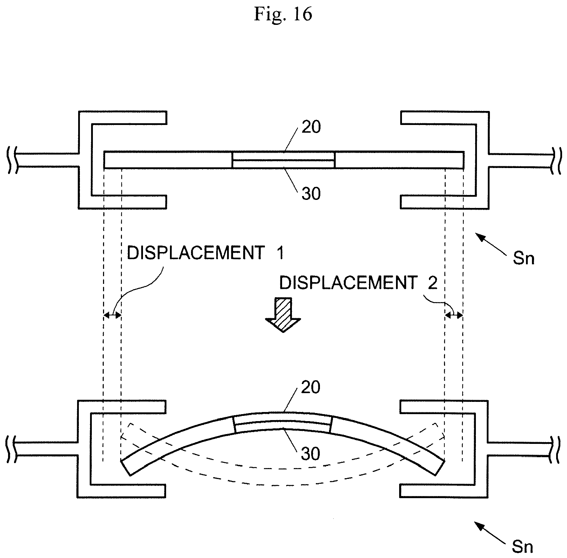

FIG. 10 is a view illustrating a method of configuring or manufacturing a piezoelectric element in a single layer or a plurality of layers so that one or both ends of the material slide when the piezoelectric element is deformed due to external energy by making the one end or the both ends of the piezoelectric element open in addition to the case in which the both ends of the piezoelectric element are fixed. Reference is made to FIG. 15 when one end is open, and reference is made to FIG. 16 when both ends are open.

As illustrated in the second and third views of FIG. 10, and in FIGS. 15 and 16, by taking a structure (the second view of in FIG. 10 and FIG. 15) in which one end of the first piezoelectric element or the second piezoelectric element is open or a structure (third view of FIG. 10 and FIG. 16) in which both ends of the first piezoelectric element or the second piezoelectric element are open, when the center of the first piezoelectric element or the second piezoelectric element is pressed by the magnetic force (a permanent magnet 20 must be located in the center in order for the center to be pressed), the first piezoelectric element or the second piezoelectric element is bent so that displacement in a horizontal direction occurs while the length of the open end of the first piezoelectric element or the second piezoelectric element is naturally reduced or increased, and as a result, there is an effect that the first piezoelectric element or the second piezoelectric element slides. Thus, a factor that inhibits the deformation of the first piezoelectric element or the second piezoelectric element due to the externally applied energy is minimized.

That is, in the case of fixing the both ends of the piezoelectric element (cantilever type), which has been mainly used to improve the output of the piezoelectric energy harvest, the fixing of both ends of the piezoelectric element is an unnecessary factor that greatly inhibits the deformation of the element with respect to the external energy applied to the element, which is a major cause of lowering the efficiency of converting the energy applied from the outside into electrical energy.

In the present disclosure, by forming one end or both ends of the piezoelectric element as an open-type, when the center of the piezoelectric element is pressed, the end of the piezoelectric element is naturally bent so that the length of the piezoelectric element is reduced and increased in a longitudinal direction resulting in a sliding effect thereby minimizing the inhibitory factors or completely eliminating the inhibitory factors in the deformation of the piezoelectric element due to the externally applied energy. Therefore, unnecessary energy consumption is minimized, thereby maximizing the energy conversion efficiency of the piezoelectric element.

In the non-contact continuous piezoelectric generator using magnetic force according to the present disclosure, the rotor 300 of FIG. 2 or FIG. 3 rotates due to various natural forces, such as wind power, tidal power, water power, and the like, or conventionally unutilized artificial energy that is not recovered but is extinguished.

Here, although a mechanical-electric energy conversion unit configured to convert mechanical energy into electrical energy may be directly connected to the non-contact continuous piezoelectric generator using magnetic force according to the present disclosure to perform the piezoelectric power generation, a mechanical energy storage configured to store the mechanical energy may be further included in front of the non-contact continuous piezoelectric generator, and thus a non-contact continuous piezoelectric power generation using magnetic force may be performed by receiving the energy stored in the mechanical energy storage. Thus, the characteristics of the continuous piezoelectric power generation may be improved so that the quality of the generated waveform may be close to a sine wave.

For example, the mechanical energy storage may have a hydraulically-stored energy spring mechanism. Alternatively, it is possible to adopt a configuration for storing mechanical energy such as vibration caused by a load of the vehicle passing through the road (pathways, highways, railways, and the like) in the form of hydraulic or pneumatic pressure and to connect the non-contact continuous piezoelectric generator of the present disclosure immediately after this configuration.

Also, the electric energy storage configured to store electrical energy generated by the non-contact continuous piezoelectric generator using magnetic force may be further included.

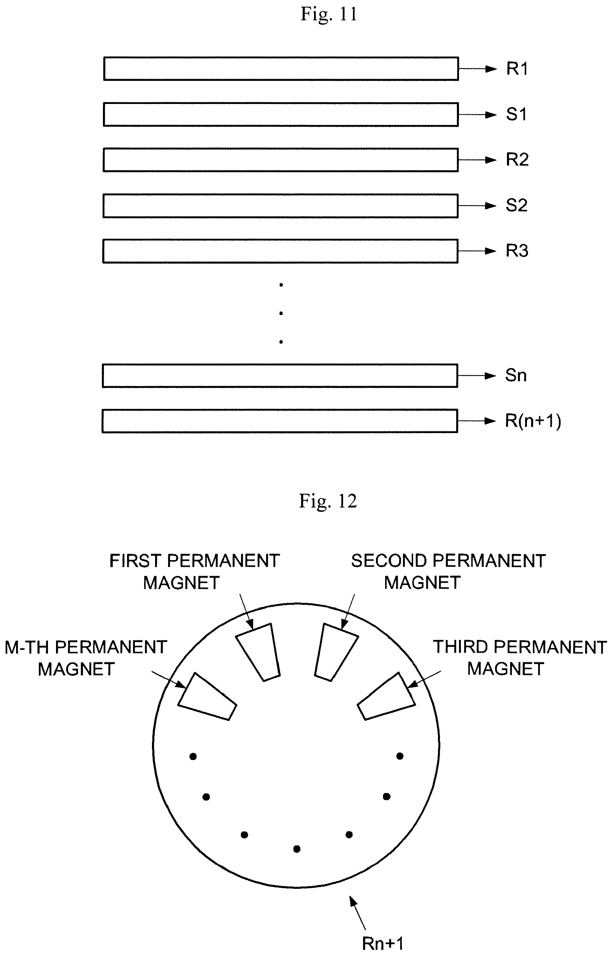

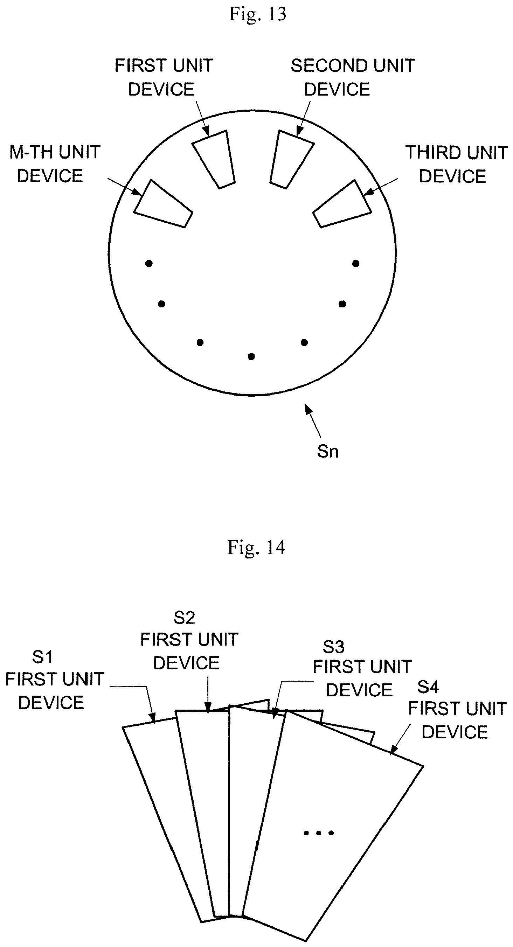

FIG. 11 illustrates a case in which the non-contact continuous piezoelectric generator using magnetic force illustrated in FIG. 4 has n+1 rotor layers and n stator layers. FIG. 12 illustrates an (n+1)-th rotor layer having a circular plate shape, on which m permanent magnets are arranged at equal intervals, in the non-contact continuous piezoelectric generator using magnetic force of FIG. 11. FIG. 13 illustrates an n-th stator layer having a circular plate shape, on which m unit devices are arranged at equal intervals, in the non-contact continuous piezoelectric generator using magnetic force of FIG. 11. FIG. 14 is a view illustrating unit devices of a first stator layer, a second stator layer, a third stator layer, and a fourth stator layer being arranged to be staggered in the non-contact continuous piezoelectric generator using magnetic force of FIG. 11 and is a conceptual diagram for dividing the magnetic force to minimize initial starting torque.

As illustrated in FIGS. 11 to 14, the non-contact continuous piezoelectric generator using magnetic force includes the n+1 rotor layers having a circular plate shape, which is configured to rotate by an external energy source, the n stator layers having a circular plate shape, which is positioned between the rotor layers, and a support structure configured to support the rotor layers and the stator layers.

Here, m permanent magnets are uniformly disposed on each of the rotor layers at a constant angle of $\frac{360}{m}$ degrees along a circumference of the rotor layer, and when viewed in a shaft direction of the non-contact continuous piezoelectric generator, the positions of the permanent magnets between the rotor layers, which are adjacent to each other, are arranged to be staggered by 180°. Here, staggering the positions of the permanent magnets between the adjacent rotor layers by 180° means that the N- and S-pole directions of the permanent magnets are reversed with relation to each other, and as a result, in the permanent magnets of adjacent rotor layers, different poles face each other in the shaft direction. Specifically, when an N-pole is positioned at an upper side of a specific rotor layer with respect to the shaft and an S-pole is positioned at a lower side of the specific rotor layer, an N-pole, which is the same pole as the N-pole of the specific rotor layer, is positioned at a lower side of a rotor layer adjacent to the specific rotor layer with respect to the shaft and faces the S-pole of the specific rotor layer in the shaft direction, and an S-pole, which is the same pole as the S-pole of the specific rotor layer, is positioned at an upper side of the rotor layer adjacent to the specific rotor layer with respect to the shaft and faces the N-pole of the specific rotor layer in the shaft direction, (see the polarities of the permanent magnets of the rotor 300 and a rotor 500 in FIG. 9).

Here, in the stator layer, the m unit devices, each of which is a combination of a permanent magnet, in which attraction and repulsion act between a permanent magnet of the rotor layer, and a piezoelectric element coupled to the permanent magnet through an intermediate medium and configured to continuously drive to generate energy, are uniformly arranged along the circumference of the stator layer at a constant angle of $\frac{360}{m}$ degrees.

Here, when the rotor layers initially start to rotate due to the external energy source, in order to minimize initial torque generated between permanent magnets present on the stator layers and the rotor layers, m permanent magnets of a k-th stator layer and m permanent magnets of a (k+1)-th stator layer do not appear to overlap each other when viewed in the shaft direction of the non-contact continuous piezoelectric generator, but the m permanent magnets of the k-th stator layer and the m permanent magnets of the (k+1)-th stator layer are arranged to be staggered by an angle of θ degrees (θ is not 0 degrees), and m permanent magnets of an n-th stator layer and m permanent magnets of a first stator layer are arranged to be staggered by the angle of θ degrees (θ is not 0 degrees and where n and m are natural numbers greater than or equal to two and k is a natural number less than or equal to n-1), (see FIG. 14).

FIG. 12 is a view illustrating a concept for dividing magnetic force in the non-contact continuous piezoelectric generator shown in FIG. 11. As illustrated in FIG. 12, the m magnets divided by an angle of 360 degrees/m are divided in the n stator layers again and staggered. Thus, as m, the number of unit devices present in the stator layer increases, a dividing angle is reduced, and thus the magnitude of initial torque becomes smaller, and as n, the number of stator layers increases, the dividing angle is reduced, and the magnitude of the initial torque becomes smaller as well. In fact, when it is not divided, there is no rotation at all due to the initial torque of several hundred to several thousand Nm (Newton meter), that is, starting is not performed at all so that the piezoelectric power generation itself has not been achieved. When 360 degrees/nm=3 degrees, i.e., when divided by an angle of 3 degrees, it is possible to lower the initial torque to 1.38 Nm. When the magnetic force between the plurality of permanent magnets is analyzed in a vector, it may be confirmed that the initial torque is lowered.

When such an implementation is generalized, when the sum of m angle differences between the m permanent magnets in the k-th stator layer and the m permanent magnets in the (k+1)-th stator layer is $\theta_k$, when θn is the sum of the differences between the angles of the m permanent magnets of the n-th stator layer and the m permanent magnets of the first stator layer, and when one of a clockwise direction and a counterclockwise direction is selected, the positive direction of $\theta_k$ may be

$$\sum_{k=1}^{n} \theta k = l \times 360 \text{ degrees}$$

when viewed in the shaft direction of the non-contact continuous piezoelectric generator, (where 1 is an integer).

Further, when the sum of m angle differences between the m permanent magnets in the k-th stator layer and the m permanent magnets in the (k+1)-th stator layer is $\theta_k$, when θn is the sum of the differences between the angles of the m permanent magnets of the n-th stator layer and the m permanent magnets of the first stator layer, and when one of the clockwise direction or the counterclockwise direction is selected, the positive direction of $\theta_k$ may be $\theta_1=\theta_2=...=\theta_k=...=\theta_n=360$ degrees/n, and

$$\sum_{k=1}^{n} \theta k = \pm 360 \text{ degrees}$$

when viewed in the shaft direction of the non-contact continuous piezoelectric generator.

The unit device has a structure which may be continuously driven on the stator layer having a circular plate shape. The unit device includes a permanent magnet, a piezoelectric element, and stainless steel (SUS) that is an intermediate medium present between the permanent magnet and the piezoelectric element. The permanent magnet is bonded to the intermediate medium using an adhesive, and the piezoelectric element is also bonded to the intermediate medium using an adhesive.

The present applicant has found a large number of cases in which the piezoelectric element is broken, that is, cracks occur in the piezoelectric element when the unit device is continuously driven. To solve this problem, a highly ductile metal thin film is coated on a piezoelectric element. Through this, it is possible to offset stress and improve tensile strength.

As a specific example, the following three cases were tested: a case in which a mesh network reinforced foam is attached on the piezoelectric element, a case in which a mesh of SUS is reinforced, and a case in which surface treatment is reinforced by coating with nickel. It was confirmed that material damage of the piezoelectric element could be most suppressed in the case in which the surface treatment is reinforced by coating the nickel on the piezoelectric element. Through the experiments, it was confirmed that the case in which the mesh network reinforced foam is attached on the piezoelectric element and the case in which the mesh of SUS is used do not show much improvement as compared to the case in which the surface treatment is reinforced by coating the nickel on the piezoelectric element, but do show an improvement as compared to the existing case in which only the piezoelectric element is present.

Further, the present applicant performed the experiment by making the SUS, that is an intermediate medium, have a plurality of perforations (holes) to enhance the adhesion between the piezoelectric element and the intermediate medium in the intermediate medium (base) of the unit device so that the piezoelectric element has a greater displacement (bending). In the case in which a plurality of perforations are provided in such an intermediate medium, especially when the unit device has a trapezoidal shape, in the trapezoidal-shaped intermediate medium, more perforations may be provided in a wider portion, and fewer perforations may be provided in a narrower portion. Thus, the adhesion between the piezoelectric element and the intermediate medium was enhanced, and the piezoelectric element may have a greater displacement, that is, the piezoelectric element may be bent greatly. Consequently, the greater displacement means more energy production.

First, according to the present disclosure, there is provided a non-contact continuous piezoelectric generator using magnetic force capable of recovering various natural forces such as wind power, tidal power, and water power, or conventionally unutilized artificial energy that is not recovered but is extinguished when rotational force is allowed to be generated or it is allowed to be switched to the rotational force even in the case in which vibration force or compressive force by an impact cannot be generated.

Second, the risk of abrasion or damage of a piezoelectric element due to an impact or a hit can be prevented in comparison with a conventional impact-based piezoelectric power generation.

Third, a non-contact continuous piezoelectric generator using magnetic force according to the present disclosure can generate a waveform in the form of a sine wave or a waveform close to a sine wave, that is, an alternating waveform with (+) and (-) unlike an impact-based piezoelectric power generation in which an undesirable waveform is generated, and thus can be expanded in various ways.

Fourth, when rotor layers start to rotate due to an external energy source, initial torque generated between permanent magnets present on a stator layer, a rotor layer starting to rotate, and another rotor layer can be minimized by dispersing and arranging the permanent magnets when viewed in a shaft direction of a non-contact continuous piezoelectric generator.

In other words, one of the major problems in implementing the deformation of a piezoelectric material in a non-contact manner using the permanent magnets is that the torque is increased enough to make the initial operation of the piezoelectric generator impossible because the quantities of permanent magnets increase as the quantities of piezoelectric materials and layers increase, and the magnitude of the magnetic force increases in proportion to the increasing. Such a problem, that is, the initial torque problem, can be minimized through the present disclosure.

Fifth, a piezoelectric energy harvesting method developed so far generates many high frequencies due to the impact of energy applied from the outside, which causes many adverse effects not only to the charging of generated electricity but also to a circuit, and an increase in internal impedance. In addition, in the case of conventional impact-based piezoelectric power generation, a device for impacting a piezoelectric material occupies most of a module, which becomes a major obstacle in improving the integration of the piezoelectric material and impacting the piezoelectric material has become a critical factor in shortening the lifespan of the material. By applying polymer to a surface of one or more piezoelectric materials to protect the material and adopting a non-contact method, the present disclosure can fundamentally solve such problems.

As described above, while the present disclosure has been described with reference to specific embodiments and drawings, the present disclosure is not limited thereto, and it is clear to those skilled in the art that various modifications and alterations may be made without departing from the scope of the present disclosure and equivalents of the appended claims.

**Claims**

1. A non-contact continuous piezoelectric generator using magnetic force, comprising:

n+1 rotor layers each having a circular plate shape and rotated by an external energy source;
n stator layers each having a circular plate shape and positioned between the rotor layers; and
a support structure configured to support the rotor layers and the stator layers,
wherein m permanent magnets (r) are uniformly disposed on each of the rotor layers at a constant angle of $\dfrac{360}{m}$ degrees along a circumference of the rotor layer, and when viewed in a shaft direction of the non-contact continuous piezoelectric generator, magnetic poles of the permanent magnets (r) between the rotor layers, which are adjacent to each other, are arranged to be staggered by 180°,
in each of the stator layers, m unit devices, each of which is a combination of a permanent magnet (r), in which attraction and repulsion act between a permanent magnet (s) of each the rotor layers, and a piezoelectric element coupled to the permanent magnet (s) through an intermediate medium and configured to continuously drive to generate energy, are uniformly arranged along a circumference of the stator layer at a constant angle of $\dfrac{360}{m}$ degrees, and
when the rotor layers start to rotate due to the external energy source, in order to minimize initial torque generated between permanent magnets present on the stator layers and the rotor layers, m permanent magnets of a k-th stator layer and m permanent magnets of a (k+1)-th stator layer do not appear to overlap each other when viewed in the shaft direction of the non-contact continuous piezoelectric generator, and the m permanent magnets of the k-th stator layer and the m permanent magnets of the (k+1)-th stator layer are arranged to be staggered by an angle of θ degrees (θ is not 0 degrees), and m permanent magnets of an n-th stator layer and m permanent magnets of a first stator layer are arranged to be staggered by the angle of θ degrees (θ is not 0 degrees and where n and m are natural numbers greater than or equal to two and k is a natural number less than or equal to n-1).

2. The non-contact continuous piezoelectric generator using magnetic force of claim 1, wherein when the sum of m angle differences between the m permanent magnets of the k-th stator layer and the m permanent magnets of the (k+1)-th stator layer is $\theta_k$, when $\theta n$ is the sum of the differences between the angles of the m permanent magnets of the n-th stator layer and the m permanent magnets of the first stator layer, and when one of a clockwise direction and a counterclockwise direction is selected, a positive direction of $\theta_k$ is $\sum_{k=1}^{n} \theta k = l \times 360$ degrees when viewed in the shaft direction of the non-contact continuous piezoelectric generator (where 1 is an integer).

3. The non-contact continuous piezoelectric generator using magnetic force of claim 1, wherein when the sum of m angle differences between the m permanent magnets of the k-th stator layer and the m permanent magnets of the (k+1)-th stator layer is $\theta_k$, when $\theta n$ is the sum of the differences between the angles of the m permanent magnets of the n-th stator layer and the m permanent magnets of the first stator layer, and when one of a clockwise direction and a counterclockwise direction is selected, a positive direction of $\theta_k$ is $\theta_1=\theta_2=...=\theta_k=...=\theta_n=\pm360$ degrees/n, and $\sum_{k=1}^{n} \theta k = \pm360$ degrees when viewed in the shaft direction of the non-contact continuous piezoelectric generator.

4. The non-contact continuous piezoelectric generator using magnetic force of any one of claims 1 to 3, wherein the unit device has a structure capable of being continuously driven on the stator layer having a circular plate shape.

5. The non-contact continuous piezoelectric generator using magnetic force of any one of claims 1 to 4, wherein the unit device is restricted in movement in a vertical direction with respect to the stator layer and only allowed to be displaced in a planar direction of the stator layer due to a stopper structure in which one end of the unit device at an inner side is fixed to an inner side of the stator layer, and the other end of the unit device at an outer side is formed on upper and lower portions of an outer circumference of the stator layer in the vertical direction with respect to the stator layer.

6. The non-contact continuous piezoelectric generator using magnetic force of any one of claims 1 to 5, wherein the unit device includes the permanent magnet (s), the piezoelectric element, and stainless steel (SUS), which is an intermediate medium present between the permanent magnet (s) and the piezoelectric element, the permanent magnet (s) is bonded to the intermediate medium using an adhesive, and the piezoelectric element is also bonded to the intermediate medium using an adhesive.

7. The non-contact continuous piezoelectric generator using magnetic force of any one of claims 1 to 5, wherein the unit device includes a two-layer piezoelectric element, and the unit device including the two-layer piezoelectric element is composed of an upper piezoelectric element, stainless steel that is an upper-intermediate medium, a permanent magnet (s), stainless steel that is a lower-intermediate medium, and a lower piezoelectric element, each of which is bonded with an adhesive and disposed in this order.

8. The non-contact continuous piezoelectric generator using magnetic force of any one of claims 1 to 5, wherein the unit device includes a three-layer piezoelectric element, and the unit device including the three-layer piezoelectric element is composed of a first piezoelectric element, stainless steel that is a first intermediate medium, a first permanent magnet (s), stainless steel that is a second intermediate medium, a second piezoelectric element, stainless steel that is a third intermediate medium, a second permanent magnet (s), stainless steel that is a fourth intermediate medium, and a third piezoelectric element, each of which is bonded with an adhesive and disposed in this order.

9. The non-contact continuous piezoelectric generator using magnetic force of any one of claims 6 to 8, wherein in the unit device, a plurality of perforations are formed in the SUS, which is the intermediate medium, so as to enhance adhesion between the piezoelectric element and the intermediate medium and to allow the piezoelectric element to have a greater displacement.

10. The non-contact continuous piezoelectric generator using magnetic force of any one of claims 1 to 9, wherein in the unit device, the piezoelectric element is reinforced by being coated with a nickel thin film.

11. The non-contact continuous piezoelectric generator using magnetic force of any one of claims 1 to 9, wherein in the unit device, a mesh network reinforcement foam is attached to the piezoelectric element so as to cover the piezoelectric element.

12. The non-contact continuous piezoelectric generator using magnetic force of any one of claims 1 to 9, wherein in the unit device, a mesh of SUS covers the piezoelectric element to reinforce the piezoelectric element.

13. The non-contact continuous piezoelectric generator using magnetic force of any one of claims 6 to 12, insofar as dependent upon any one of claims 6 to 8, wherein in the unit device, when the permanent magnet (s) is subjected to the attraction and repulsion by the permanent magnets of the rotor layer and the stator layer, an intermediate position of the unit device formed at an intermediate position of SUS, which is the intermediate medium, in a circumferential direction moves in a vertical direction with respect to the stator layer, and an outer end of the unit device is restricted in movement in the vertical direction with respect to the planar direction of the stator layer of the unit device due to a stopper structure in which the outer end is formed on upper and lower portions of an outer circumference of the stator layer in the vertical direction with respect to the stator layer, and as a result, the unit device is displaced only in the planar direction of the stator layer so that the unit device is driven continuously to generate energy.

Fig. 1

Fig. 2

Fig. 3

Fig. 4

Fig. 5

R1  S1  S2  S3  S4  S5  S6  R2

X

Fig. 6

R1  DS1 S1  S2  S3  S4  DS2 R2

X

Fig. 7

(a)

R1 S1 R2 S2

(b)

R2    S2

R1    S1
R1    S1

R2
S2

Fig. 8

CRANKSHAFT

CRANKSHAFT

Crank

Crank

Fig. 9

Fig. 10

Fig. 11

→ R1

→ S1

→ R2

→ S2

→ R3

.
.
.

→ Sn

→ R(n+1)

Fig. 12

FIRST PERMANENT
MAGNET

SECOND PERMANENT
MAGNET

M-TH PERMANENT
MAGNET

THIRD PERMANENT
MAGNET

Rn+1

Fig. 13

FIRST UNIT
DEVICE

SECOND UNIT
DEVICE

M-TH UNIT
DEVICE

THIRD UNIT
DEVICE

Sn

Fig. 14

S2
FIRST UNIT
DEVICE

S3
FIRST UNIT
DEVICE

S1
FIRST UNIT
DEVICE

S4
FIRST UNIT
DEVICE

. . .

Fig. 15

DISPLACEMENT

20

30

Sn

20

30

Sn

Fig. 16

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2018/236061 A1 (AMC GLOBIZ CO LTD [KR]) 27 December 2018 (2018-12-27) * paragraph [0050]; figures 1-4 * | 1-7 | INV. H01L41/09 H02N2/18 |
| X | KR 2018 0138521 A (AMC GLOBIZ CO LTD [KR]) 31 December 2018 (2018-12-31) * paragraph [0048] - paragraph [0065]; figures 1-4 * | 1 | |
| X | CN 102 223 106 A (YAOYU ZHOU) 19 October 2011 (2011-10-19) * the whole document * | 1 | |

TECHNICAL FIELDS
SEARCHED      (IPC)

H01L
H02N

The present search report has been drawn up for all claims

| Place of search | Date of completion of the search | Examiner |
|---|---|---|
| Munich | 3 June 2020 | Angermeier, Detlef |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 19 21 0311

This annex lists the patent family members relating to the patent documents cited in the above-mentioned European search report.
The members are as contained in the European Patent Office EDP file on
The European Patent Office is in no way liable for these particulars which are merely given for the purpose of information.

03-06-2020

| Patent document cited in search report | Publication date | Patent family member(s) | Publication date |
|---|---|---|---|
| WO 2018236061 A1 | 27-12-2018 | NONE | |
| KR 20180138521 A | 31-12-2018 | NONE | |
| CN 102223106 A | 19-10-2011 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020190098416

- KR 1380538